(19) Europäisches Patentamt
European Patent Office
Office européen des brevets

(11) EP 1 751 789 B1

## (12) EUROPEAN PATENT SPECIFICATION

(45) Date of publication and mention
of the grant of the patent:
**22.07.2015 Bulletin 2015/30**

(21) Application number: **04774546.8**

(22) Date of filing: **09.09.2004**

(51) Int Cl.:
***H01L 21/20*** *(2006.01)*

(86) International application number:
**PCT/KR2004/002287**

(87) International publication number:
**WO 2005/106934 (10.11.2005 Gazette 2005/45)**

(54) **FLEXIBLE ELECTRO-OPTICAL APPARATUS AND METHOD FOR MANUFACTURING THE SAME**

FLEXIBLE ELEKTROOPTISCHE VORRICHTUNG UND HERSTELLUNGSVERFAHREN DAFÜR

DISPOSITIF ELECTRO-OPTIQUE SOUPLE ET PROCEDE DE FABRICATION

(84) Designated Contracting States:
**AT BE BG CH CY CZ DE DK EE ES FI FR GB GR HU IE IT LI LU MC NL PL PT RO SE SI SK TR**

(30) Priority: **28.04.2004 US 833051**

(43) Date of publication of application:
**14.02.2007 Bulletin 2007/07**

(73) Proprietor: **IUCF-HYU (INDUSTRY-UNIVERSITY COOPERATION FOUNDATION HANYANG UNIVERSITY) Seoul 133-791 (KR)**

(72) Inventors:
• **PARK, Jong-Wan**
  **Namyangju 472-962 (KR)**
• **PARK, Jae-Gun**
  **Sungnam 463-500 (KR)**

(74) Representative: **Michalski Hüttermann & Partner Patentanwälte mbB Speditionstraße 21 40221 Düsseldorf (DE)**

(56) References cited:
WO-A-2004/042780        JP-A- 3 250 666
JP-A- 8 288 522          JP-A- 2003 150 087
KR-A- 2004 064 601       KR-A- 2004 093 948
KR-A- 2004 100 469       KR-A- 20040 093 948
US-A1- 2003 222 334

## Description

### Technical Field

The present invention relates to a flexible electro-optical apparatus such as a flexible high-resolution liquid crystal display wherein single-crystal silicon semiconductor is used in manufacturing driver circuits and pixel arrays, and a method for manufacturing the same. A thinning technique of a single-crystal silicon wafer is employed to manufacture flexible devices of desired characteristics. By applying a design rule of a general semiconductor manufacturing process and manufacturing an active layer of devices from single-crystal silicon, a flexible and high-resolution electro-optical apparatus, such as a liquid crystal display, is manufactured.

### Background Art

The maximum resolution of the existent liquid crystal display is 180 ppi (pixel per inch) in an amorphous-silicon TFT (thin film transistor) device (for example, a 15-inch QXGA notebook by Samsung Electronics Co., Ltd.), or 202 ppi in a low temperature poly-silicon (LTPS, low temperature poly-silicon) TFT device (for example, a 4-inch VGA product by LG-Philips-LCD). The resolution of about 200 ppi corresponds to 120 to 130 μm in pixel size.

Compared with amorphous-silicon TFTs, general low temperature poly-silicon TFTs have good current driving properties and can easily reduce device size to manufacture a high-resolution display. However, since there are grain size limitations of crystallized silicon, reducing the size of a TFT device to below the level of 4 or 5 μm is often difficult. Alignment accuracy of a photolithographic apparatus used in a TFT LCD manufacturing process is also very low compared to that of a semiconductor processing apparatus, and wet etching has been employed in most patterning and etching processes. As such, the design rule of several micrometers has been applied to manufacturing a display, making it difficult to manufacture a high-resolution display of 200 ppi or more.

Since the display using high temperature poly-silicon (HTPS; high temperature poly-silicon) TFTs is manufactured from a quartz wafer as a substrate by employing a semiconductor manufacturing process, the high-resolution display, of which the pixel is of about 14 μm, can.be manufactured. However, since most of the high temperature poly-silicon TFT LCDs, which are used in manufacturing a projector and the like, display colors using three panels, each of which has a single color of red (R), green (G), and blue (B), it is, strictly speaking, difficult to achieve the pixel of 14 μm compared to that of a full color display. In addition, since there are some device performance limitations of high temperature poly-silicon devices, it is not an easy task to integrate complicated system circuits or reduce the size of a pixel device.

As a method for manufacturing a high-resolution display, the liquid crystal display, of which the devices are manufactured by applying a semiconductor manufacturing process to a single-crystal silicon wafer, is often manufactured in order to overcome the limitation of poly-silicon in the LCoS (Liquid Crystal on Silicon) technique. Since the silicon wafer in this case is an opaque substrate, the liquid crystal display is manufactured as a reflective LCD type. The liquid crystal display may be manufactured as a transmissive LCD type by manufacturing TFTs on a wafer, removing a portion of the wafer, and transferring it onto a glass substrate. A general flexible display is manufactured by forming low temperature poly-silicon TFTs on a general glass substrate, removing the glass substrate with H2 and laser, and transferring it to a flexible substrate. However, it is difficult to achieve high-resolution because of the performance limitation on electronic devices of low temperature poly-silicon TFTs. A flexible display can be manufactured by forming amorphous-silicon TFTs or low temperature poly-silicon TFTs on a flexible substrate as another method for manufacturing a flexible display. However, achieving a liquid crystal display cf high-resolution is not easy due to limitation cf the processing temperature of the flexible substrate and low performance of the device.

The WO 2004/042780 discloses a rollable device having a substrate of an insulating material with apertures which connect an electrode and a functional layer.

### Disclosure of Invention

### Technical Problem

In order to solve the above-mentioned problems, it is an object of the present invention to provide a flexible electro-optical apparatus such as a flexible liquid crystal display manufactured by forming driver circuits and pixel arrays from a nano SOI (silicon-on-insulator) single-crystal wafer through a semiconductor manufacturing process, to which the fine design rule can be applied, and removing the lower portion of the wafer, and a method for manufacturing the same.

It is another.object of the present invention to provide a flexible electro-optical apparatus which has good device characteristics and a high aperture ratio by employing single-crystal silicon in manufacturing devices such as TFTs, and a method for manufacturing the same.

It is still another object of the present invention to provide a high-resolution flexible electro-optical apparatus which has very small pixels and can be easily manufactured by increasing the aligning margin when bonding an upper substrate portion and a lower substrate portion by forming the R, G and B color filters above TFT arrays and integrating them, and a method for manufacturing the same.

It is still another object of the present invention to provide a high-resolution flexible electro-optical apparatus which can provide a flexible SOD (system on display) that embeds various driver circuits in the display panel due to good device characteristics and reliability, and a method for manufacturing the same.

**Technical Solution**

According to one aspect to the present invention, a flexible electro-optical apparatus comprises a flexible lower substrate portion including device layers where electronic devices are formed on a flexible single-crystal layer; a flexible upper substrate portion to be bonded to the lower substrate portion; and an electro-optical material layer between the lower substrate portion and the upper substrate portion.

The flexible single-crystal layer may be a nano SOI layer. The nano SOI layer may be from 20 to 400 nm in thickness and comprise silicon or compound semiconductor. The upper substrate portion may comprise a flexible transparent substrate, electrodes, and a flexible polarizing plate. The lower substrate portion may comprise a flexible transparent substrate, a flexible polarizing plate, and/or a flexible backlight. The device layers may comprise a reflective plate, which has metal pixel electrodes and be integrated with color filters. Column spacers may be formed on the device layers through a semiconductor photolithographic process. The device layers may comprise interlayer dielectrics of organic matter. The electronic devices may comprise pixel arrays and driver circuits. Preferably, the pixel arrays comprise the pixels of 300 to 1,000 ppi, and the driver circuits comprise gate driver circuits and data driver circuits. The gate electrodes of the electronic devices may comprise poly-silicon, metal, metal-silicon compound or metal/poly-silicon double layer. The electronic devices may be insulated with STI (shallow trench isolation) structure. Also, the electronic devices may be LDD (lightly doped drain) structures.

According to another aspect to the present invention, a method for manufacturing a flexible electro-optical apparatus comprises the steps of manufacturing a lower substrate portion wherein a single-crystal layer is formed on the upper surface of the lower substrate portion; forming device layers wherein electronic devices are formed on the flexible single-crystal layer; manufacturing a transparent upper substrate portion; bonding the lower substrate portion and the upper substrate portion; injecting an electro-optical material between the lower substrate portion and the upper substrate portion; and making the bonded lower and upper substrate portions flexible.

When the upper substrate portion is flexible, the bonded lower and upper substrate portions may become flexible by removing the lower portion of the lower substrate portion. When the transparent upper substrate portion includes an upper supporting substrate, the bonded lower and upper substrate portions may become flexible by removing the upper supporting substrate, and removing the remaining lower portion after grinding. Before removing the upper supporting substrate, the lower portion of the lower substrate portion may be ground to a predetermined thickness. The upper supporting substrate may be removed after removing the remaining lower portion after grinding. The remaining lower portion may be removed by wet etching the entire lower portion of the lower substrate portion. Otherwise, the remaining lower portion may be removed by covering a peripheral portion of the bonded lower and upper substrate portions to expose a portion of the lower portion of the lower substrate portion, removing the portion of the lower portion by wet etching it, and cutting the peripheral portion of the bonded lower and upper substrate portions. KOH may be used in wet etching the entire lower surface or the portion of the lower surface. The device layers may be formed by employing a semiconductor manufacturing process, to which a design rule from 0.13 to 0.03 $\mu$m may be applied. The device layers may be formed by forming TFT arrays and driver circuits on the single-crystal layer simultaneously, forming color filters on the TFT arrays and driver circuits, forming pixel electrodes which are connected to TFTs on the color filters, forming spacers patterned above the color filters, and forming one or more alignment films above the pixel electrodes and the color filters. Preferably, the color filters are formed before pixel electrodes are formed. After the color filters are formed, an organic transparent layer may be formed to compensate for the difference of thickness all over the color filters. After TFT arrays and driver circuits are formed on the single-crystal layer simultaneously, black matrices may be formed above the TFT devices. The transparent upper substrate portion may be manufactured by forming electrodes on a surface of a flexible transparent substrate, forming one or more alignment films on the electrodes, and bonding an upper supporting substrate on the other surface of the flexible transparent substrate with an adhesive film. In this case, the bonded lower and upper substrate portions become flexible by removing the upper supporting substrate, for example by irradiating it with UV. The one or more alignment films may be formed after the upper supporting substrate is bonded.

**Description of Drawings**

Fig. 1(a) shows schematic views of a liquid crystal display; and Fig. 1(b) shows a schematic plain view of a unit cell of a TFT LCD.

Fig. 2 shows views of the process for providing a nano SOI single-crystal wafer and forming active regions for a driver circuit region and a pixel array region of the display.

Fig. 3 shows views of the process for forming a gate insulator film with thermal oxide, doping to form an electrode of a storage capacitor, and n- doping to form gate electrodes and LDDs (lightly doped drains).

Fig. 4 shows views of the process for forming side-wall spacers to form offsets for defining LDD regions when n+ and p+ doping.

Fig. 5 shows views illustrating the doping process for forming sources and drains of the active regions though n+(P) and p+(B) ion implantations.

Fig. 6 shows views of the process for forming and connecting data electrodes after depositing a silicon oxide film ($SiO_2$) as a first interlayer dielectric and forming contact holes.

Fig. 7 shows views of the process for depositing a second interlayer dielectric ($SiO_2$, SiN, or $Si_3N_4$) for insulating the data electrodes from a black matrix and forming the black matrix.

Fig. 8 shows views of the process for integrating each of the red, green, and blue color filters onto a TFT array region in order to manufacture a high-resolution LCD.

Fig. 9 shows views of the process for forming transparent ITO (indium tin oxide) pixel electrodes, forming patterned column spacers for maintaining the gaps between cells, and forming a lower alignment film for aligning liquid crystal on a TFT array substrate through printing, sintering, and rubbing processes.

Fig. 10 shows views of the process for forming an upper alignment film through printing, sintering, and rubbing processes after bonding a transparent glass-supporting substrate for facilitating handling to the upper substrate portion, on which a transparent ITO common electrode is deposited.

Fig. 11 shows a view of the lower substrate portion and upper substrate portion which are bonded, between which the liquid crystal is injected, and which are sealed.

Fig. 12 shows views of the process for etching the entire lower portion of the nano SOI single-crystal wafer as an embodiment for removing the lower portion by etching it.

Fig. 13 shows views of the process of another embodiment for removing the lower portion by holding the peripheral portion of the bonded upper and lower substrate portions, etching a portion of the lower portion excluding the peripheral portion, and removing the peripheral portion.

Fig. 14 shows a view of the flexible transparent plastic substrate bonded on the surface wherein the lower portion of the nano SOI single-crystal wafer is removed.

Fig. 15 shows a view of the process for removing the upper transparent supporting substrate by irradiating with UV an adhesive film, which bonds the upper transparent supporting substrate to the upper substrate portion.

Fig. 16 shows a view of the display according to the present invention, which is completed by bonding a flexible transparent plastic substrate to the etched lower portion of the high-resolution flexible TFT LCD using the nano SOI single-crystal wafer, bonding a flexible polarizing plate to the upper and lower surfaces thereof, respectively, and bonding a flexible backlight to the lower surface thereof.

Fig. 17 shows a view of the display according to the present invention, which is completed by bonding the flexible polarizing plate to the upper surface and the etched lower surface, respectively, of the high-resolution flexible TFT LCD using the nano SOI single-crystal wafer and bonding the flexible backlight to the lower surface thereof, without bonding the flexible transparent plastic substrate.

Fig. 18 shows schematic views of two transmissive optical apparatuses, wherein the transmissive optical apparatus of Fig. 18(b) further includes a flexible transparent plastic substrate on the lower substrate portion contrary to the apparatus of Fig. 18(a).

Fig. 19 shows schematic views of two reflective optical apparatuses, wherein the reflective optical apparatus of Fig. 19(b) further includes a flexible reflective plate on the lower substrate portion contrary to the apparatus of Fig. 19(a).

Figs. 20, 21 and 22 show views of another embodiment for removing the lower portion of the lower substrate portion. '

Fig. 23 shows views of the process of another embodiment for forming the lower substrate portion with an STI (shallow trench isolation) method applied to the nano SOI single-crystal wafer on which the active patterns are formed as shown in Fig. 1(b).

Fig. 24 shows views of the process of still another embodiment for forming the lower substrate portion with the STI method applied to the nano SOI single-crystal wafer on which the active patterns are formed as shown in Fig. 1(b).

## Best Mode

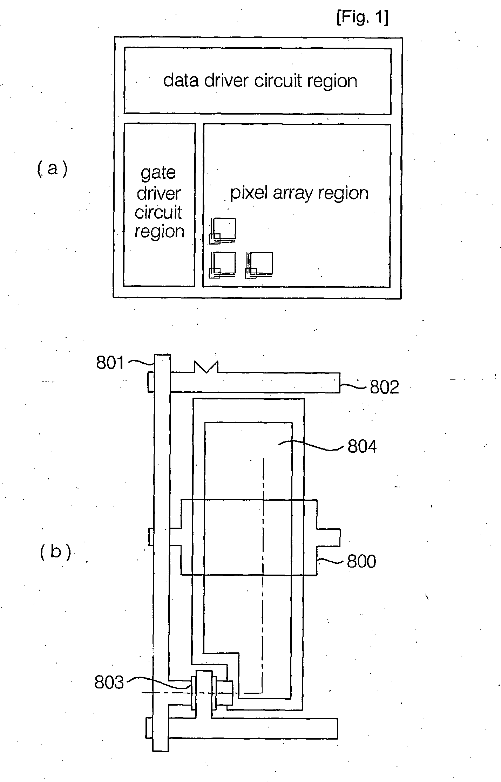

Figs. 1 to 17 show an embodiment according to the present invention for manufacturing the high-resolution flexible liquid crystal display using single-crystal silicon to form an active layer.

With the present invention, it is possible to integrate pixel arrays and various driver circuits for driving the pixel arrays on the same panel and simultaneously manufacture them as shown in Fig. 1(a) since single-crystal silicon is used in forming devices. Therefore, the present embodiment illustrates the process for manufacturing the pixel arrays and the driver circuits simultaneously, wherein the region where the pixel arrays are manufactured is indicated as a pixel array region, and the region where the driver circuits are manufactured is indicated as a driver circuit region. As shown in Fig. 1(b), a unit pixel cell of a representative liquid crystal display comprises a TFT 803, a pixel electrode 804 connected thereof, and a storage capacitor 800. The position of the storage capacitor can be changed as required, and the storage capacitor is formed in a ring shape so that it can function as a black mask simultaneously as itself. The manu facturing process of the present embodiment is illustrated with cross-sectional views, which are taken from the side of the unit pixel cell, cut as indicated by the dotted line.

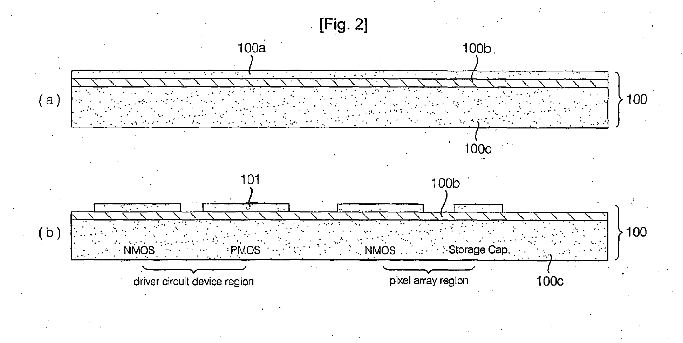

Fig. 2(a) shows a nano SOI single-crystal wafer 100 used as a lower substrate portion of the present invention. The nano SOI single-crystal wafer 100 comprises a silicon base 100c, which is a lower portion of the single-crystal wafer, and a buried oxide film 100b and a single-crystal layer 100a, which are accumulated on the silicon base 100c. The single-crystal layer 100a such as a defect-free single-crystal silicon layer is used as an active layer, and can be formed with the thickness of 400 to below 30 nm. The thickness of the defect-free single-crystal layer is controlled through the process of manufacturing the nano SOI single-crystal wafer. The buried oxide film 100b as an insulation layer functions as an etching stopper when removing the silicon base 100c by etching it and can be formed to be below 200 nm in thickness. The nano SOI single-crystal wafer may be manufactured by employing wafer thinning and adhesion techniques. For the method for manufacturing the nano SOI single-crystal wafer, please refer to U.S. Patent Application Serial No. US10/391,297.

The nano SOI single-crystal wafer 100 of Fig. 2(a), which is manufactured as above, is provided with active regions 101 through photolithographic and dry etching processes, as shown in Fig. 2(b). Insulator films are formed between the active regions (i.e., the device regions) to electrically insulate them. The present embodiment employs the method for forming insulator films during the device forming process, wherein the films separate the device regions laterally on which unit cells or other devices of a semiconductor substrate will be formed, without an additional field insulation process.

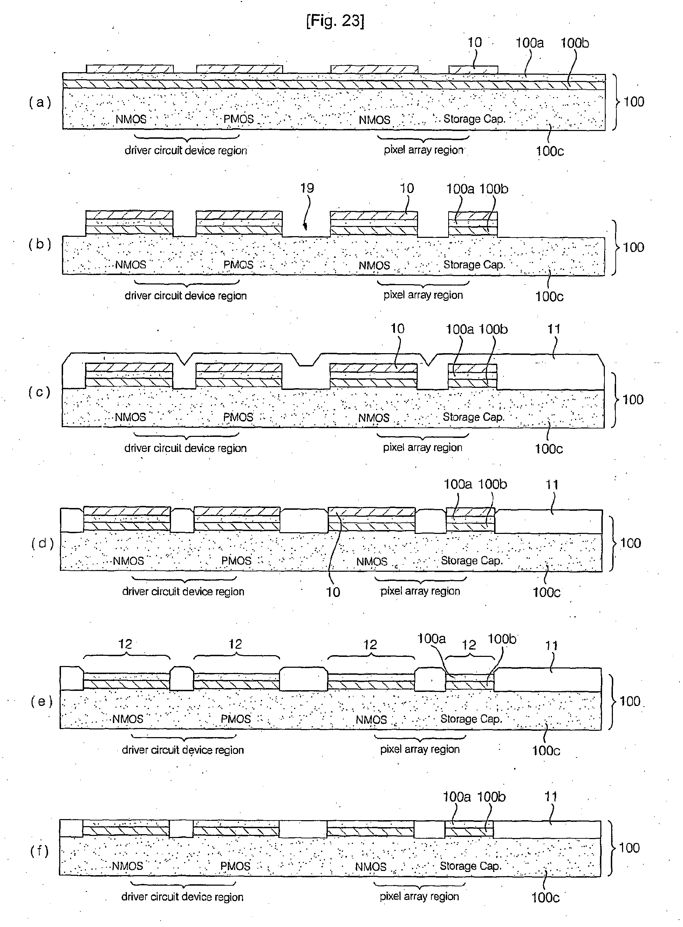

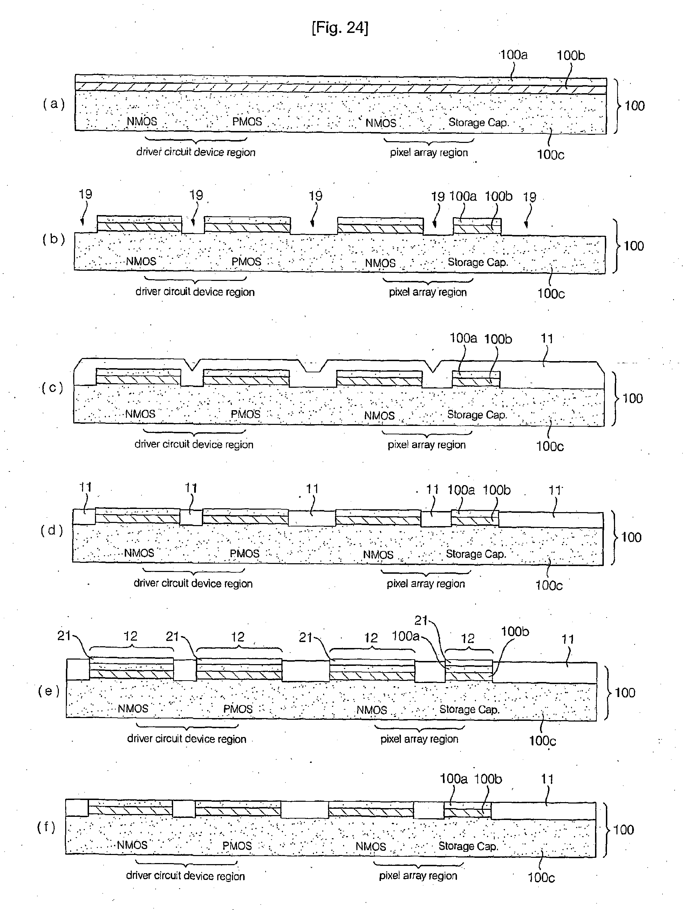

In addition to the field insulation process, other various well-known methods are employed. Particularly, the STI (shallow trench isolation) technique, an alternative method of forming isolation regions between active devices, can make the distance between devices close enough to increase the aperture ratio of a pixel. Figs. 23 and 24 illustrate two embodiments of the STI process, in addition to the method shown in Fig. 2. As shown in Figs. 23(a) and 23(b), in order to pattern active region 12, which are shown in Fig. 23(e), trenches 19 are formed by patterning a silicon nitride film ($Si_3N_4$) 10 on the nano SOI single-crystal wafer 100 and etching the region to be filled with field insulator films. Then, as shown in Fig. 23(c), the nano SOI single-crystal wafer 100 is covered with a field insulator film 11 by employing the chemical vapor deposition (CVD) method. Preferably, the field insulator film 11 may be a silicon oxide film. In Fig. 23(d), the field insulator film 11 of predetermined thickness is removed by chemical mechanical polishing (CMP), so that only the field insulator film 11 in the trenches 19 remains. Through this process, the active regions 12 are separated. by the field insulator film 11. With the active regions 12 separated, the silicon nitride films 10 left above the active regions 12 are removed, as shown in Fig. 23(e), to perform the post process. Next, planarization of the surface as shown in Fig. 23(f) is performed.

Fig. 24 shows another embodiment of the STI process which is employed in the present invention. That is, a portion of the single-crystal layer 100a and the buried oxide 100b of the nano SOI silicon substrate 100 of Fig. 24(a) is etched, so that the trenches 19 are formed as shown in Fig. 24(b). Then, as shown in Fig. 24(c), the nano SOI silicon substrate 100 is covered with the field insulator film 11. The field insulator film 11 is flattened by employing the CMP method (Fig. 24(d)). Thermal oxide films 21 are formed above the active regions 12 in order to remove impurities, as shown in Fig. 24(e). Then, the separation between the active regions 12 is completed by removing the thermal oxide films 21 by etching them. Employing the STI processes as above, the active regions 12 in the nano SOI silicon substrate 100 are separated. Then the devices are formed in the active regions 12. In addition to these STI processes, other various well-known STI processes may be employed.

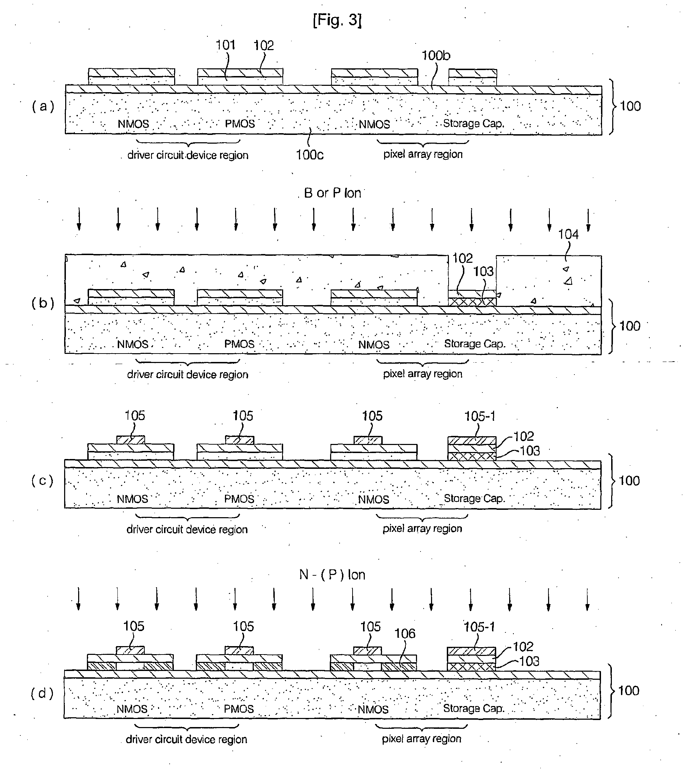

Fig. 3 shows views of the process for forming gate insulator films from thermal oxide, doping to form an electrode of a storage capacitor, and n- doping to form gate electrodes and LDDs.

After forming active regions in the nano SOI single-crystal wafer 100 through the process of Fig. 2 (otherwise, Fig. 23 or Fig. 24), gate insulator films 102 are formed from thermal oxide films as shown in Fig. 3(a). Although the post process after the STI processes of Figs. 23 and 24 is not illustrated, the following processes are similar.

After forming the active patterns and gate insulator films as above, a lower electrode 103 of the storage capacitor in the pixel array region is doped by ion implanting B(p+) or P(n+) as shown in Fig. 3(b), after a storage photolithographic process is performed for masking a portion not including the storage capacitor with photoresist 104.

As shown in Fig. 3(c), gate electrodes 105 of the driver circuit region and the pixel array region and an upper electrode 105-1 of the storage capacitor are formed through depositing and patterning processes.

When forming the gate electrodes 105, high concentration poly-silicon (n+) is generally used. Since the load of electrode lines increases as the size of a panel increases due to the characteristics of a TFT LCD, duplicate layers of tungsten and poly-silicon (n+), instead of poly-silicon, are used as gate electrodes in order to decrease the resistance of the electrode. Also, metal-based material such as W, W/WN, TiSi$_2$, WSi$_2$, or Mo may be used as electrodes.

After forming the gate electrodes 105, as shown in Fig. 3(d), an n- doped drain 106 is formed by ion implanting phosphorus (P) in order to form the LDD structure by employing a self-aligning non-photolithographic technique.

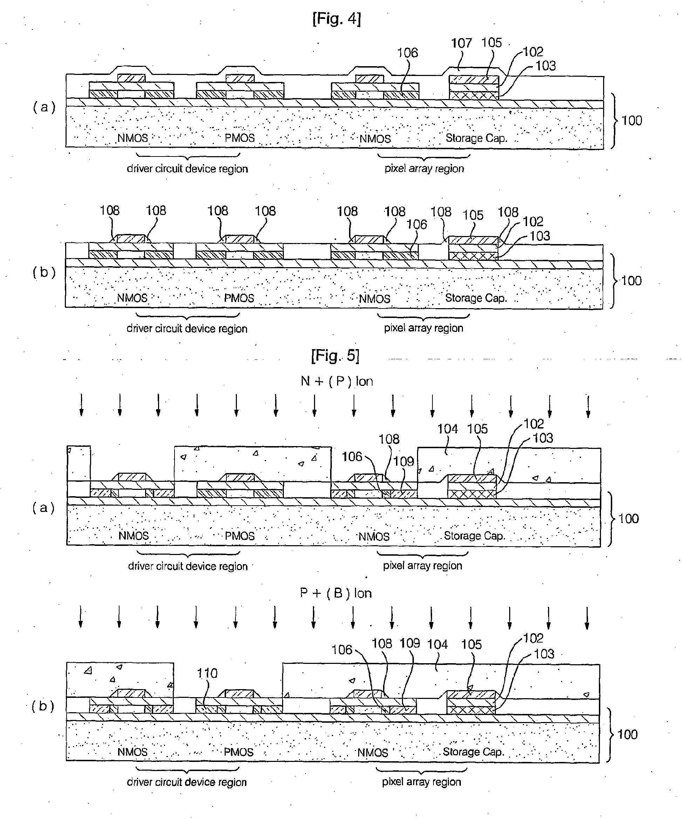

In order to form offsets with side-wall spacers which protect n- doping portions cf the LDD structure, as shown in Fig. 4(a), an oxide film (SiO$_2$) 107 is deposited throughout. Then, the side-wall spacers 108 are formed through a dry etching process as shown in Fig. 4(b). In comparison with the method of forming TFTs by patterning through a photolithographic process and doping impurities in general LTPS and HTPS, the present invention employs a method for forming LDDs by forming side-wall spacers and doping with high concentration, making it possible to prevent deviation from misalignment in the photolithographic process. Thus, uniform and reliable TFT devices can be manufactured.

After n- doping and forming the side-wall spacers 108, n+ doping is performed through a phosphorus (P) ion implantation process, as shown in Fig. 5(a), in order to form an n+ region of the LDD structure and source 110 and drain 109 regions. In order to form the source 110 and drain 109 regions of a PMOS, P+ doping is performed through a boron (B) ion implantation process, as shown in Fig. 5(b). The transistors of the LDD structure are completed by activating the doping regions formed as above through a furnace annealing process at over 800 °C. Although the transistors of LDD structure are explained in the present embodiment, well-known transistors cf various structures may be manufactured by employing a semiconductor manufacturing process according to the desired device characteristics.

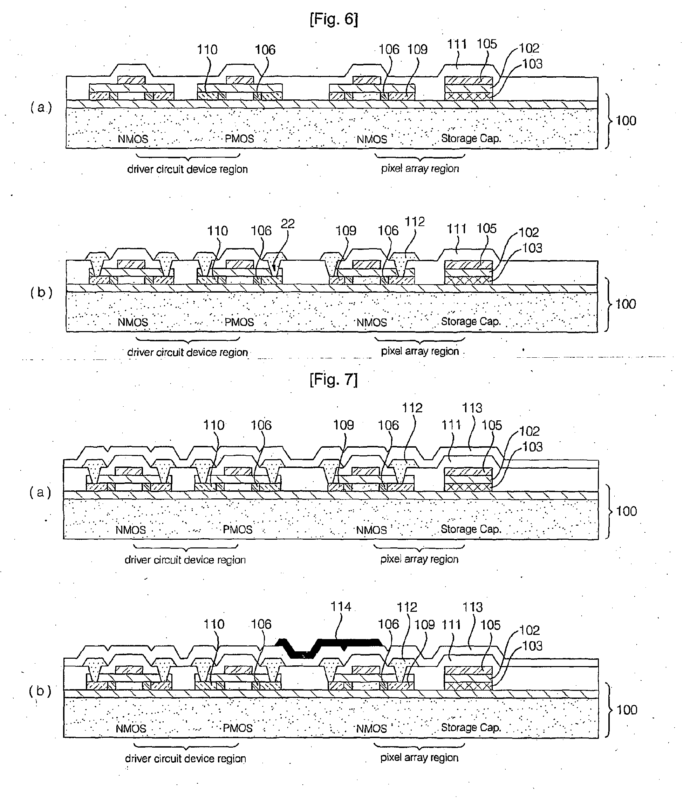

Next, as shown in Fig. 6(a), a first interlayer dielectric 111 for insulating the data electrodes and the gate electrodes is formed by depositing an insulator film such as a silicon oxide film. Since inorganic matter used as an interlayer dielectric is not flexible, organic matter can be used as an interlayer dielectric. Also, since the interlayer dielectric is deposited on the entire surface of the substrate, it functions as an isolation film between various devices.

After forming the interlayer dielectric as above, as shown in Fig. 6(b), contact holes 22 are formed, and data electrodes 112 are deposited and patterned. The data electrodes 112 are formed by sputtering Al and TiN.

Then, a color filter plate is manufactured, which includes color filter patterns for embodying colors, a black matrix for separating R, G, and B cells and intercepting light, and a common electrode (ITO; indium tin oxide) for applying voltage to liquid crystal cells.

As shown in Fig. 7(a), a second interlayer dielectric 113 is deposited on the substrate, on which the data electrodes are formed, with SiO$_2$, SiN, Si$_3$N$_4$, SiON or other insulation organic matter by employing CVD. A black matrix 114 is formed in order to prevent optical leakage at the gate and data electrodes 105, 112 and the TFT array regions, as shown in Fig. 7(b). A black matrix is generally formed as a film by sputtering Cr, CrOx/Cr, black photoresist, MoOX, and the like.

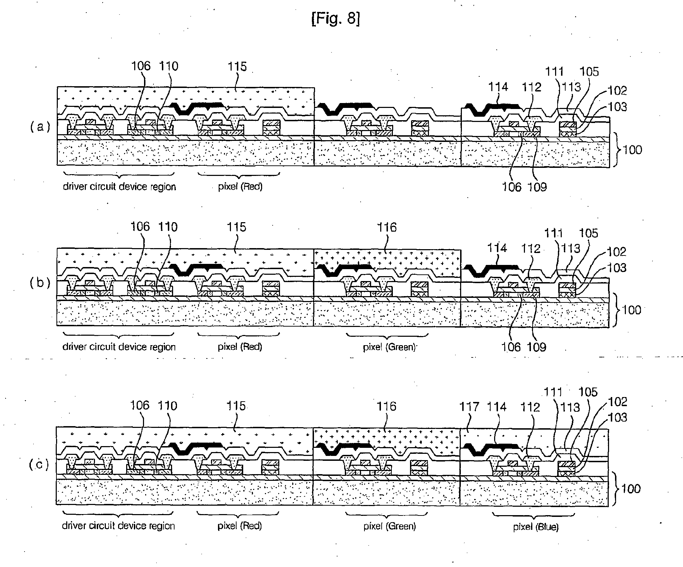

As shown in Fig. 8, color filters 115, 116, 117 are formed on the TFT arrays which are manufactured by patterning the photoresists, each of which has red 115, green 116, and blue 117, respectively. Since the lower substrate, on which the TFT array regions are formed, and the upper substrate, on which the color filters 115, 116, 117 are formed, are bonded later in conventional method, precise aligning margin is required when bonding the TFT array regions and the color filters 115, 116, 117. If the alignment of the TFT array regions and the color filters 115, 116, 117 exceeds the aligning margin, i.e. misalignment, optical leakage occurs, and the desired performance cannot be reached when driving the display. However, the present invention can solve the above problems by patterning the photoresists for color filters on the TFT array regions directly as described above. After the color filters are completed as shown in Fig. 8(c), a transparent organic matter for compensating the difference in thickness of the color filters (not shown) may be coated on the entire surface of the color filters since color reproducibility can be decreased due to the difference of gaps between the cells, which is caused by the difference in the thickness of the color filters. If the color filters are integrated on the TFT array regions as above, the high-resolution LCD can be manufactured since the aligning margin, when bonding the TFT array regions and the color filters 115, 116, 117, is not necessary.

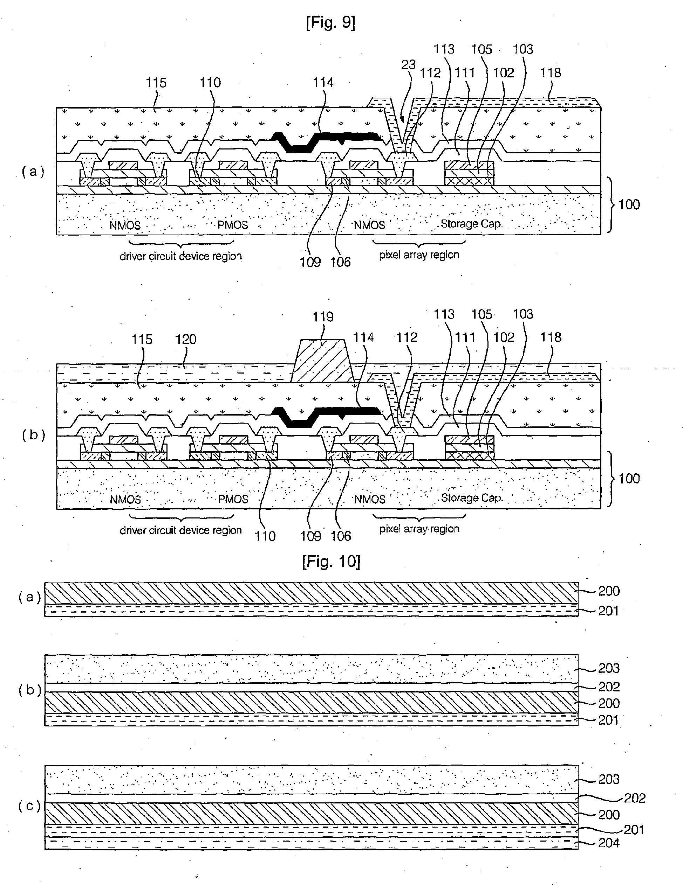

After forming the color filters, as shown in Fig. 9(a), a contact hole 23 is manufactured by etching the color filter 115, 116, or 117 and the interlayer dielectric 113 in order to connect the TFT (NMOS) device and the pixel electrode. A pixel electrode 118 is formed by depositing and patterning the transparent electrode in the contact hole 23 and on the color filter 115 with ITO, and the like. The pixel electrode 118 may be made from metal such as Al in order to be used also as a reflective plate. To manufacture a reflective liquid crystal display, a metal pixel electrode, which can function as a reflective plate, may be formed under the color filter. Otherwise, after forming a separate metal reflective plate, transparent pixel electrodes may be formed through the above process.

As shown in Fig. 9(b), a column spacer 119 which is patterned above the black matrix 114 is formed, so that the space for injecting liquid crystal between the lower substrate portion, i.e., the nano SOI single-crystal wafer 100 and an upper substrate portion 600, including a transparent flexible plastic substrate, a flexible polarizing plate, and electrodes. The column spacer 119 may be made from organic matter such as photoresist or inorganic matter, for instance, silicon oxide and silicon nitride. In a general liquid crystal display, it is important to maintain the space between two substrates uniformly because the liquid crystal display is driven by applying voltage to liquid crystal molecules injected into the uniform space between the upper substrate portion and lower substrate portion. If the distance between the upper substrate portion and the cells in the lower substrate portion is not uniform, the difference of lighttransmissivity in the cells can cause a non-uniform brightness. Thus, in the present embodiment, by positioning the column spacers precisely, the space between both the substrates is maintained uniformly all over the substrates.

The lower substrate portion is completed by coating an alignment film 120 on the TFT arrays and the color filters formed as described above and sintering and rubbing it.

Fig. 10 shows views of the process for manufacturing the upper substrate portion 600. As shown in Fig. 10(a), a transparent ITO electrode 201 is coated on the lower surface of a flexible transparent plastic substrate 200, and a upper transparent supporting substrate 203 as an upper supporting substrate may be bonded on the upper surface of the flexible transparent plastic substrate 200. In order to easily remove the upper transparent supporting substrate 203, it may be bonded with adhesive film 202 which is removed by irradiating it with UV. The supporting substrate is useful in handling the bonding of the nano SOI single-crystal wafer 100 and the upper substrate portion 600 and removing the silicon base 100c of the wafer 100. The removal of the silicon base 100c is achieved by wet etching it with KOH. It is preferable to employ the supporting substrate 203 since the device arrays may be subjected to incidental stress after etching the silicon base 100c, the LCD with the silicon base 100c removed may be subjected to bending, or the upper and lower substrate portions may be separated.

In the meantime, if inorganic matter such as $SiO_2$ or SiN is used as the first or second interlayer dielectric, the film may be fractured or the gate electrodes or the data electrodes may be broken. In addition, the stress produced in making the substrate flexible cannot be relieved. Thus, as the present embodiment, it is preferable to employ organic matter as an insulator film.

An alignment film 204 is printed, sintered, and rubbed on the transparent common electrode 201 of the upper substrate portion 600. In order to sinter a polyimide-based polymer compound which is used as alignment films 120, 204 of the upper and lower substrate portions in the present embodiment, a temperature of 200 °C is required. Also, the adhesive film 202 for bonding the glass supporting substrate 203 on the flexible transparent plastic substrate 200 may be sensitive to temperature. Therefore, the glass supporting substrate may be bonded after forming the alignment films to the transparent common electrode.

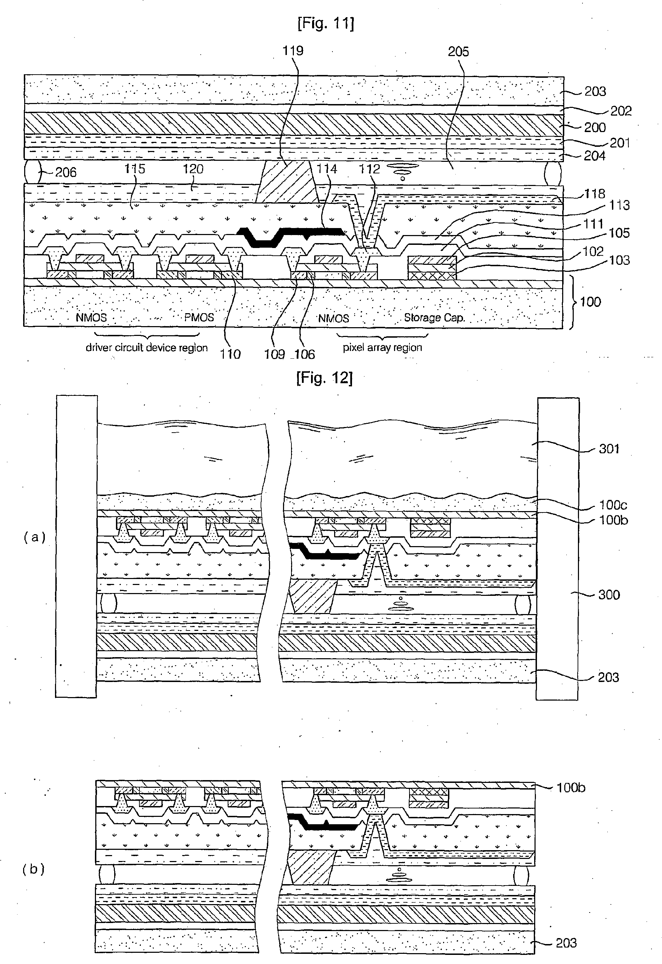

As shown in Fig. 11, after bonding the upper substrate portion and the lower substrate portion, between which liquid crystal 205 is injected, they are sealed with sealant 206.

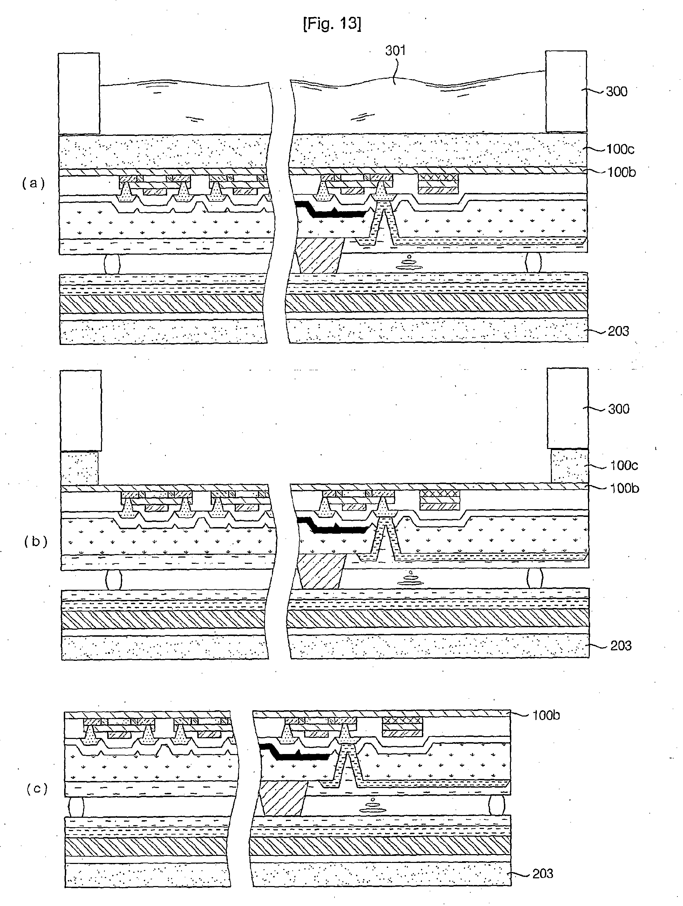

As shown in Figs. 12 and 13, the flexible liquid crystal display is completed by removing the silicon base 100c from the bonded upper and lower substrate portions by using an etching jg 300. Fig. 12 is an example of removing the silicon base 100c by etching it with KOH 301 after holding the edges of the bonded upper and lower substrate portions by the etching jig 300. As shown in Fig. 12, the pixel array region and the driver circuit regoin can be protected from KOH by the buried oxide 100b when the silicon base 100c is removed by etching.

Another example of removing the silicon base 100c is shown in Fig. 13. As il-lustrated in Fig. 13(a), a portion of the silicon base 100c is etched with KOH 301 after holding the peripheral portion of the bonded upper and lower substrate portions by the etching jg 300. Fig. 13(b) shows the bonded upper and lower substrate portions of which the portion of the silicon base 100c is removed by etching it. As illustrated in Fig. 13(c), the removal of the silicon base 100c is completed by cutting the peripheral portion of the bonded upper and lower substrate portions of which the silicon base 100c is not yet removed since it is held by the etching jg 300.

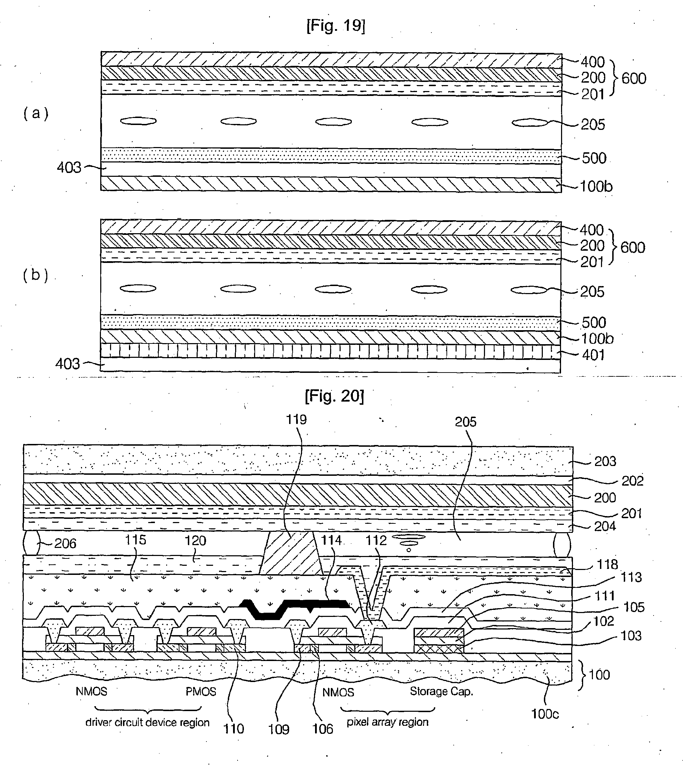

Figs. 20, 21 and 22 show views of another embodiment for removing the silicon base 100c of the lower substrate portion. With the upper transparent supporting substrate 203 attached, as shown in Fig. 20, the silicon base 100c of the lower substrate portion is ground to the desired thickness. The thickness can be desirously adjusted in grinding, for example from 50 $\mu$m to 200 $\mu$m.

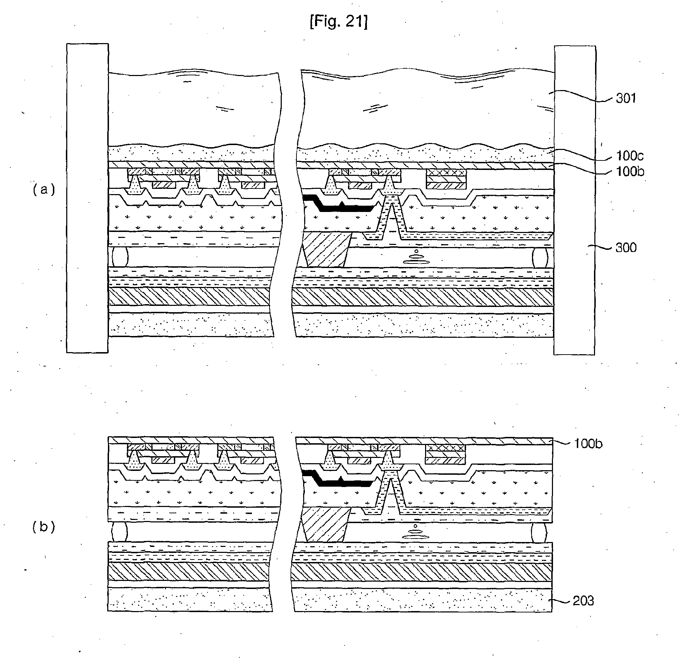

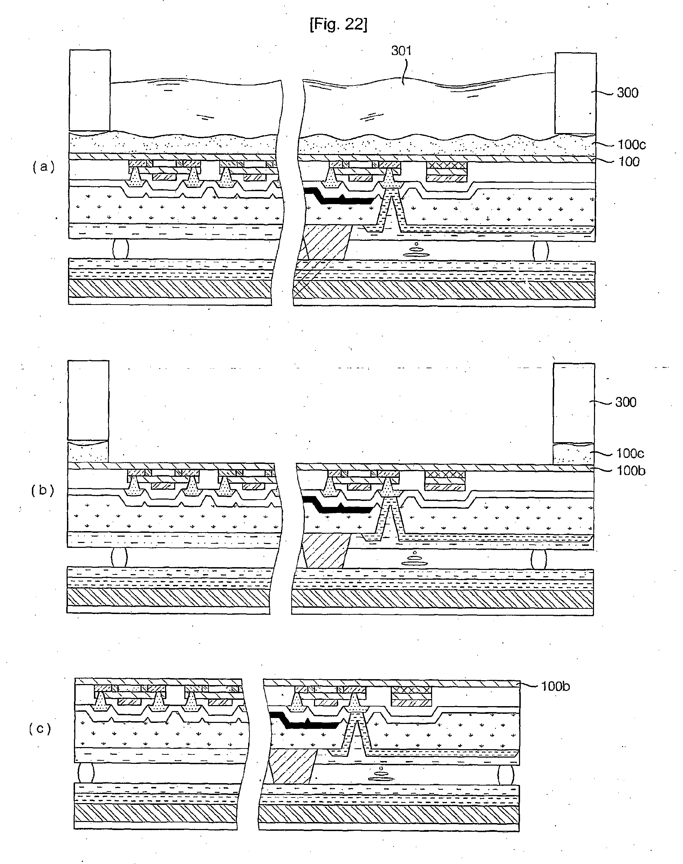

After grinding the silicon base 100c, the remaining silicon base 100c after grinding is removed by wet etching it with a KOH solution as shown in Figs. 21 and 22. Fig. 21 shows the process for removing the remaining silicon base 100c by etching it, which is similar to the process shown in Fig. 12; while Fig. 22 shows the process for removing the remaining silicon base 100c by holding the peripheral portion of the bonded upper and lower substrate portions, etching a portion of the lower portion excluding the peripheral portion, and removing the peripheral portion, which is similar to the process shown in Fig. 13.

The upper transparent supporting substrate 203 is removed by irradiating it with UV, after the remaining silicon base 100c is removed (as shown in Fig. 21), or before the remaining silicon base 100c is removed (as shown in Fig. 22).

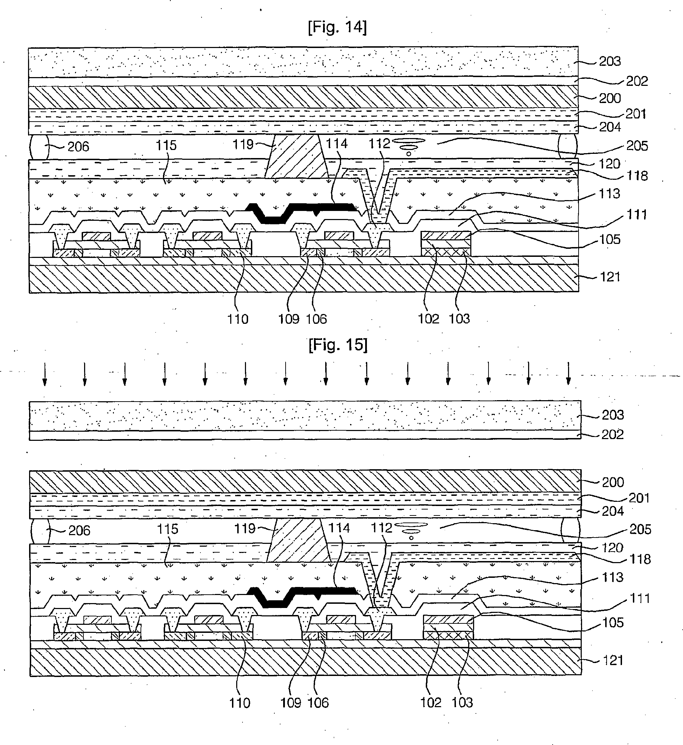

After removing the silicon base 100c, a flexible transparent plastic substrate 121 may be bonded on the lower substrate portion as shown in Fig. 14 in order to prevent the bonded upper and lower substrate portions from being contaminated and to properly align the polarizing direction when bonding the polarizing plate. However, a polarizing plate 401 may be directly bonded to the surface of the lower substrate portion of which the silicon base 100c is removed without the flexible transparent plastic substrate 121.

After the silicon base 100c is removed from the lower substrate portion as described above, the bonded upper and lower substrate portions become flexible, as shown in Fig. 15, by removing the upper transparent supporting substrate 203 by irradiating it with UV.

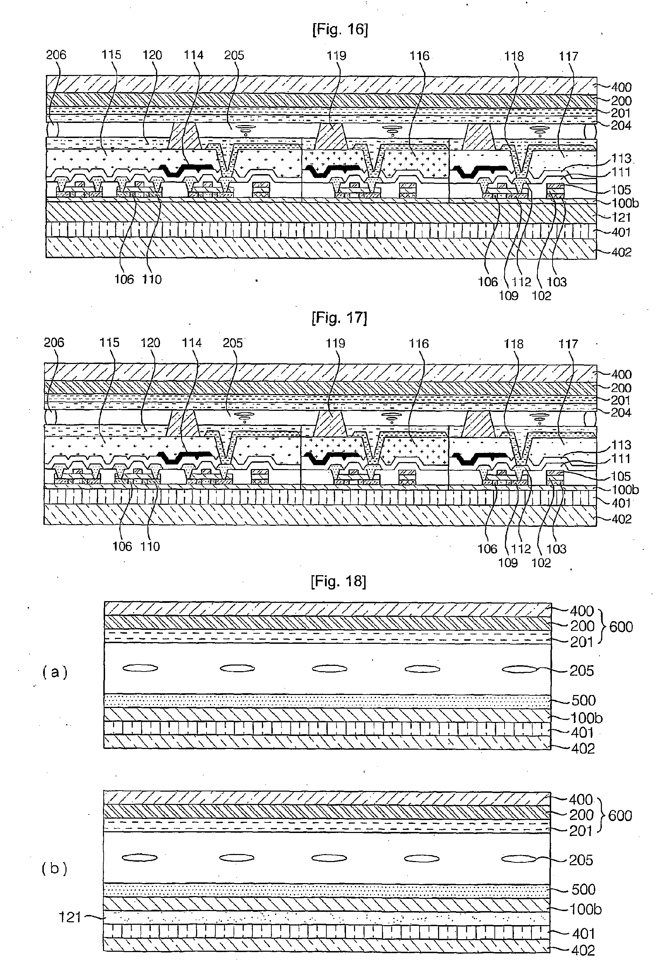

As shown in Figs. 16 and 17, the flexible transmissive liquid crystal display of the present invention is completed by bonding an upper flexible polarizing plate 400 on the upper substrate portion, and bonding a lower flexible polarizing plate 401 and a flexible backlight 402 on the lower substrate portion. Fig. 16 shows the display wherein the flexible transparent plastic substrate 121 is bonded on the lower substrate portion before bonding the polarizing plate; and Fig. 17 shows the display wherein the polarizing plate is bonded directly on the lower substrate portion without bonding a flexible transparent plastic substrate.

A liquid crystal does not emit light by itself and only modulates transmitted light. Since a liquid crystal panel is below 10 % in transmissivity, the backlight for an LCD, wherein sufficient uniform brightness over the entire display panel is maintained, is required. The backlight may be manufactured from a fluorescent lamp, an LED, an inorganic EL, an organic EL, and the like. The backlight functions to make plane light of uniform brightness. With the exception of backlight, the liquid crystal display is manufactured to be thin, increasing optical efficiency and decreasing power consumption.

Conventional low temperature poly-silicon TFTs or high temperature poly-silicon TFTs, which use amorphous silicon by crystallizing it, have very high defect density due to a grain boundary and the like. However, the liquid crystal display with devices manufactured from the single-crystal layer as described above may use the defect-free single-crystal silicon as an active layer because the nano SOI single-crystal wafer 100 is used as the lower substrate portion of the present invention. In addition, since the liquid crystal display of the present invention can be treated under a high temperature, a general semiconductor manufacturing process can be applied. Thus, an excellent thermal oxide film can be used as a gate insulator film. Also, the TFT devices have excellent device characteristics and reliability. Since a design rule of 0.13 to 0.03 $\mu$m (130 to 30 nm) can be applied, it is possible to manufacture a high-resolution TFT LCD which has fine pixels of 500 to above 1000 ppi and a high aperture ratio. Further, the liquid crystal display according to the present invention has excellent device characteristics and flexibility.

Although the process for manufacturing the transmissive liquid crystal display is described in the present embodiment, the liquid crystal display of the present invention can be a reflective liquid crystal display by forming a reflective plate, without backlight, below the color filters.

Fig. 18 shows flexible transmissive liquid crystal displays. A reference numeral 500 denotes simplified layers on the buried oxide film 100b wherein the electronic devices are formed on the single-crystal layer. In the flexible transmissive liquid crystal display of Fig. 18(a), the lower polarizng plate 401 is bonded on the buried oxide after removing the silicon base 100c of the lower substrate portion by etching it. In the flexible transmissive liquid crystal display of Fig. 18(b), the polarizing plate 401 is bonded on the flexible transparent plastic substrate 121 on the lower substrate portion which is bonded after removing the silicon base 100c by etching it. Then, the flexible backlight 402 is bonded on the lower polarizing plate 401 in the flexible transmissive liquid crystal displays of Figs. 18(a) and 18(b).

Fig. 19 shows flexible reflective liquid crystal displays in which backlight is not needed. The flexible reflective liquid crystal display of Fig. 19(a) with a reflective plate 403 formed in a liquid crystal panel, which uses one sheet of the polarizing plate 400, employs a reflective STN (super twisted nematic) mode, an ECB (electrically controlled birefringence) mode, an OCB (optically compensated bend) mode, or the like. The pixel electrodes 118 may be used as a reflective plate by manufacturing the pixel electrodes 118 from metal such as Al. The flexible reflective liquid crystal display of Fig. 19(b) with the flexible reflective plate 403 bonded on the lower polarizing plate 401 may employ a TN (twisted nematic) mode, an STN mode, or the like. However, since two polarizing plates 400, 401 are used, the brightness is weak. The flexible electro-optical apparatus of the present invention may be applied to various liquid crystal displays in addition to the transmissive and reflective displays.

In the flexible electro-optical apparatus of the present invention, the active layer for the pixel arrays and driver circuits of the electro-optical apparatus are formed from single-crystal silicon by thinning a single-crystal silicon wafer, manufacturing the nano SOI single-crystal wafer, and etching the lower portion of the single-crystal silicon wafer. Also, the semiconductor manufacturing process is applied to manufacturing the flexible electro-optical apparatus. Thus, as shown in Table 1, electronic mobility is 1000 cm$^2$/V sec which is very high compared to that of other silicon matter. Also, electronic devices possess superior characteristics, and leakage current is also considerably reduced to below 100 times as opposed to that of conventional poly-silicon TFTs.

Table 1. Electronic Mobility in Various Silicon Materials

| Silicon Materials | Electronic Mobility |
|---|---|
| Amorphous silicon | 0.1 ~ 0.4 cm$^2$/Vsec |
| High temperature poly-silicon | 100 cm$^2$/Vsec |
| Low temperature poly-silicon | 100 ~ 150 cm$^2$/Vsec |
| CG (continuous grain) silicon | 300 cm$^2$/Vsec |

(continued)

| Silicon Materials | Electronic Mobility |
|---|---|
| Nano-SOI single-crystal silicon | 1000 cm$^2$/Vsec |

With the present invention, it is possible to reduce the size of a TFT to the level of general semiconductor devices. That is, the size of devices can considerably be reduced by applying a design rule of about 30 nm, which can be practicable at present, by a stable high-temperature process and semiconductor photolithographic and etching processes having good alignment accuracy, since the semiconductor manufacturing process is applied to silicon wafers. Thus, it is possible to manufacture the electro-optical apparatus which realizes the R, G, and B colors in one panel and has a high resolution of above 1,000 ppi. The design rules applicable according to types of silicon for manufacturing TFTs are listed in Table 2. The design rule for nano SOI single-crystal silicon is fine as up to 0.13 ~ 0.03 μm. The maximum resolutions and pixel sizes for kinds of commercially available silicon are listed in Table 3. In color mode of nano SOI single-crystal silicon, the pixel size is 25.4 μm x 8.46 μm and a resolution is above 1000 ppi, which is excellent compared to that of other silicon matter.

Table 2. Design Rule in Various Silicon Materials

| Silicon Materials | Design Rule |
|---|---|
| Amorphous silicon | 10 μm |
| High temperature poly-silicon | 0.8 μm |
| Low temperature poly-silicon | 3 ~ 4 μm |
| Nano-SOI single-crystal silicon | 0.13 ~ 0.03 μm |

Table 3. Current Accomplished Resolution in Silicon Materials

| Silicon Materials | Color | Sub Pixel Size | Resolution |
|---|---|---|---|
| Amorphous silicon | Color | 148.5 × 49.5 μm | 171 ppi |
| High temperature poly-silicon | Color (monochrome) | 14 × 14 μm | 604 ppi (1814 ppi) |
| Low temperature poly-silicon | Color | 126 × 42 μm | 202 ppi |
| Nano-SOI single-crystal silicon | Color | 2.54 × 8.46 μm | above 1000 ppi |

In addition, in the electro-optical apparatus of the present invention, which are manufactured by improving the device characteristics and applying the fine design rule, it is possible to design a very large-scale integration device because the size of devices is reduced and alignment accuracy is improved. In addition, since the narrow gaps between devices can improve the aperture ratio, it is also expected to improve display performance such as brightness, contrast, and the like.

Also, it is possible to manufacture the flexible electro-optical apparatus by removing the lower portion of the single-crystal silicon and making it into a flexible substrate. Theoretical flexibility of single-crystal silicon, the radius of curvature, at which the single-crystal silicon is fractured when bent, can be calculated. The stress when the silicon wafer with a thickness of d is bent to the radius of curvature of R, can be calculated as follows:

$$\sigma = (d/2R)E \; (< \sigma_y \; and < \sigma_f)$$

where, σ is stress, d is thickness, R is the radius of curvature, E is Young's modulus, $\sigma_y$ is yield stress, and $\sigma_f$ is fracture stress.

In general, E is 190 GPa, $\sigma_y$ is 6.9 GPa, and $\sigma_f$ is 2.8 GPa. Hence, the theoretical fracture curvature-radius of the single-crystal silicon of e.g. 5μm in thickness is estimated to be 0.17 mm. It was actually confirmed that the silicon wafer of 5μm in thickness according to the present invention can be bent without fracture at least at the radius of curvature of less than 3 mm. Therefore, it is noted that the flexible electro-optical apparatus according to the present invention can possess desired flexibility.

## Industrial Applicability

Since the present invention can use stable channel devices of single-crystal, the present invention enables an SOP (system on panel), where all driver circuits are embedded in the panel, and embedded devices, where various memories, system ICs, processors, specific semiconductor circuits, and the like are embedded in a chip according to the device purpose, to be flexible.

Although the present invention is described in detail with the embodiments, the invention is not limited thereto and can be changed or modified by those skilled in the art within the spirit and scope of the invention.

## Claims

1.   A method for manufacturing a flexible electro-optical apparatus, comprising the steps of:

  manufacturing a lower substrate portion (100) wherein a single-crystal layer (100a) is formed on the upper surface of said lower substrate portion (100);
  forming device layers wherein electronic devices are formed on the single-crystal layer (100a);
  manufacturing a transparent upper substrate portion (600) with an upper supporting substrate (203) bonded to it;
  bonding said lower substrate portion (100) and said upper substrate portion (600);
  injecting an electro-optical material between said lower substrate portion (100) and said upper substrate portion (600);
  and making said bonded lower and upper substrate portions flexible;
  wherein said upper substrate portion (600) is flexible, and the step of making said bonded lower and upper substrate portions flexible comprises the step of holding the bonded upper and lower substrate portions by an etching jig (300) and removing a lower portion (100c) of said lower substrate portion (100);
  removing said upper supporting substrate (203).

2.   The method according to claim 1, wherein said single-crystal layer (100a) on said lower substrate portion (100) comprises a nano SOI single-crystal layer through an SOI manufacturing process.

3.   The method according to claim 1, wherein the step of making said bonded lower and upper substrate portions flexible comprises the step of removing the entire lower portion (100c) of said lower substrate portion (100) by wet etching it.

4.   The method according to claim 1, wherein the step of making said bonded lower and upper substrate portions flexible comprises the steps of covering a peripheral portion of said bonded lower and upper substrate portions to expose a portion of the lower portion (100c) of said lower substrate portion (100), removing the portion of the lower portion (100c) by wet etching it, and cutting the peripheral portion of said bonded lower and upper substrate portions.

5.   The method according to claim 3, wherein KOH is used in wet etching the entire lower surface.

6.   The method according to claim 4, wherein KOH is used in wet etching the portion of the lower surface.

7.   The method according to claim 1, wherein said transparent upper substrate portion (600) includes an upper supporting substrate (203); and wherein the step of making said bonded lower and upper substrate portions flexible comprises the steps of grinding the lower portion (100c) of said lower substrate portion (100) to a predetermined thickness, removing the upper supporting substrate (203), and removing the remaining lower portion after grinding.

8.   The method according to claim 1, wherein said transparent upper substrate portion (600) includes an upper supporting substrate; and wherein the step of making said bonded lower and upper substrate portions flexible comprises the steps of grinding the lower portion of said lower substrate portion to a predetermined thickness, removing the remaining lower portion after grinding, and removing the upper supporting substrate.

9.   The method according to claim 8, wherein the step of removing the remaining lower portion after grinding comprises the step of removing the entire lower portion of said lower substrate portion by wet etching it.

10.   The method according to claim 8, wherein the step of removing the remaining lower portion after grinding comprises the steps of covering a peripheral portion of said bonded lower and upper substrate portions to expose a portion of the lower portion of said lower substrate portion, removing the portion of the lower portion by wet etching it, and cutting the peripheral portion of said bonded lower and upper substrate portions.

11. The method according to claim 9, wherein KOH is used in wet etching the entire lower surface.

12. The method according to claim 10, wherein KOH is used in wet etching the portion of the lower surface,

13. The method according to any one of claims 1 to 12, wherein the step of forming the device layers employs a semiconductor manufacturing process.

14. The method according to claim 13, wherein a design rule from 0,13 to 0,03 $\mu$m is applied to the semiconductor manufacturing process.

15. The method according to any one of claims 1 to 12, wherein the step of forming the device layers comprises the steps of forming TFT arrays and driver circuits on said single-crystal layer (100a) simultaneously, forming color filters (115, 116, 117) on said TFT arrays and driver circuits, forming pixel electrodes (118) which are connected to TFTs on said color filters (115, 116, 117), forming spacers patterned above said color filters, and forming one or more alignment films (120) above said pixel electrodes (118) and said color filters (115, 116, 117).

16. The method according to any one of claims 1 to 12, wherein the step of forming the device layers comprises the steps of forming TFT arrays and driver circuits on said single-crystal layer (100a) simultaneously, forming pixel electrodes (118) which are connected to TFTs on said TFT arrays and driver circuits, forming color filters (115, 116, 117) on said pixel electrodes (118), forming spacers patterned above said color filters (115, 116, 117), and forming one or more alignment films (120) on said pixel electrodes (118) and said color filters (115, 116, 117).

17. The method according to claim 15, after the step of forming said color filters (115, 116, 117), further comprising the step of forming an organic transparent layer to compensate for the difference of thickness all over the color filters (115, 116, 117).

18. The method according to claim 15, after the step of forming TFT arrays and driver circuits on said single-crystal layer simultaneously, further comprising the step of black matrices (114) above the TFT devices.

19. The method according to claim 15, wherein the step of forming the device layers employs a semiconductor manufacturing process.

20. The method according to any one of claims 1 to 12, wherein the step of manufacturing the transparent upper substrate portion (600) comprises the steps of forming electrodes on a surface of a flexible transparent substrate, forming one or more alignment films on said electrodes, and bonding an upper supporting substrate on the other surface of the flexible transparent substrate with an adhesive film; and the step of making said bonded lower and upper substrate portions flexible comprises the step of removing said upper supporting substrate.

21. The method according to claim 15, wherein the step of manufacturing the transparent upper substrate portion (600) comprises the steps of forming electrodes on a surface of a flexible transparent substrate, forming one or more alignment films on said electrodes, and bonding an upper supporting substrate on the other surface of the flexible transparent substrate with an adhesive film; and the step of making said bonded lower and upper substrate portions flexible comprises the step of removing said upper supporting substrate.

22. The method according to claim 21, wherein the step of removing said upper supporting substrate (203) comprises the step of removing it with UV.

23. The method according to any one of claims 1 to 12, wherein the step of manufacturing the transparent upper substrate portion (600) comprises the steps of forming electrodes on a surface of a flexible transparent substrate, bonding an upper supporting substrate on the other surface of the flexible transparent substrate with an adhesive film, and forming one or more alignment films on said electrodes; and the step of making said bonded lower and upper substrate portions flexible comprises the step of removing said upper supporting substrate.

24. The method according to claim 21, wherein the step of making said bonded lower and upper substrate portions flexible comprises the step of removing the entire lower portion of said lower substrate portion by wet etching it.

**25.** The method according to claim 21, wherein the step of making said bonded lower and upper substrate portions flexible comprises the steps of covering a peripheral portion of said bonded lower and upper substrate portions to expose a portion of the lower portion of said lower substrate portion, removing the portion of the lower portion by wet etching it, and cutting the peripheral portion of said bonded lower and upper substrate portions.

**26.** The method according to claim 19, wherein the step of manufacturing the transparent upper substrate portion comprises the steps of forming electrodes on a surface of a flexible transparent substrate, forming one or more alignment films on said electrodes, and bonding an upper supporting substrate on the other surface of the flexible transparent substrate with an adhesive film; and the step of making said bonded lower and upper substrate portions flexible comprises the steps of removing the entire lower portion by wet etching it with KOH and removing said upper supporting substrate with UV.

## Patentansprüche

**1.** Verfahren zum Herstellen einer flexiblen elektrooptischen Vorrichtung, mit den Schritten:

Herstellen eines unteren Substratabschnitts (100), wobei eine Einkristallschicht (100a) auf der Oberseite des unteren Substratabschnitts (100) ausgebildet wird;

Ausbilden von Bauelementschichten, wobei elektronische Bauelemente auf der Einkristallschicht (100a) ausgebildet werden;

Herstellen eines transparenten oberen Substratabschnitts (600) mit einem damit verbundenen oberen Trägersubstrat (203);

Verbinden des unteren Substratabschnitts (100) mit dem oberen Substratabschnitt (600);

Einspritzen eines elektrooptischen Materials zwischen dem unteren Substratabschnitt (100) und dem oberen Substratabschnitt (600); und

Flexibelmachen der miteinander verbundenen unteren und oberen Substratabschnitte;

wobei der obere Substratabschnitt (600) flexibel ist, und wobei der Schritt zum Flexibelmachen der miteinander verbundenen unteren und oberen Substratabschnitte den Schritt zum Halten der miteinander verbundenen oberen und unteren Substratabschnitte durch eine Ätz-Haltevorrichtung (300) und das Entfernen eines unteren Abschnitts (100c) des unteren Substratabschnitts (100) aufweist; und

Entfernen des oberen Trägersubstrats (203).

**2.** Verfahren nach Anspruch 1, wobei die Einkristallschicht (100a) auf dem unteren Substratabschnitt (100) eine durch einen SOI-Herstellungsprozess ausgebildete Nano-SOI-Einkristallschicht aufweist.

**3.** Verfahren nach Anspruch 1, wobei der Schritt zum Flexibelmachen der miteinander verbundenen unteren und oberen Substratabschnitte den Schritt zum Entfernen des gesamten unteren Abschnitts (100c) des unteren Substratabschnitts (100) durch Nassätzen aufweist.

**4.** Verfahren nach Anspruch 1, wobei der Schritt zum Flexibelmachen der miteinander verbundenen unteren und oberen Substratabschnitte die Schritte zum Abdecken eines Umfangsabschnitts der verbundenen unteren und oberen Substratabschnitte derart, dass ein Teil des unteren Abschnitts (100c) des unteren Substratabschnitts (100) frei liegt, Entfernen des Teils des unteren Abschnitts (100c) durch Nassätzen und Schneiden des Umfangsabschnitts der verbundenen unteren und oberen Substratabschnitts aufweist.

**5.** Verfahren nach Anspruch 3, wobei beim Nassätzen der gesamten unteren Fläche KOH verwendet wird.

**6.** Verfahren nach Anspruch 4, wobei beim Nassätzen des Teils der unteren Fläche KOH verwendet wird.

**7.** Verfahren nach Anspruch 1, wobei der transparente obere Substratabschnitt (600) ein oberes Trägersubstrat (203) aufweist, und wobei der Schritt zum Flexibelmachen der miteinander verbundenen unteren und oberen Substratabschnitte die Schritte zum Schleifen des unteren Abschnitts (100c) des unteren Substratabschnitts (100) auf eine vorgegebene Dicke, das Entfernen des oberen Substratabschnitts (203) und das Entfernen des übrigen unteren Abschnitts nach dem Schleifen aufweist.

**8.** Verfahren nach Anspruch 1, wobei der transparente obere Substratabschnitt (600) ein oberes Trägersubstrat aufweist, und wobei der Schritt zum Flexibelmachen der miteinander verbundenen unteren und oberen Substratabschnitte die Schritte zum Schleifen des unteren Abschnitts des unteren Substratabschnitts (100) auf eine vorgegebene Dicke, das Entfernen des übrigen unteren Substratabschnitts nach dem Schleifen und das Entfernen des oberen Trägersubstrats aufweist.

9. Verfahren nach Anspruch 8, wobei der Schritt zum Entfernen des übrigen unteren Abschnitts nach dem Schleifen den Schritt zum Entfernen des gesamten unteren Abschnitts des unteren Substratabschnitts durch Nassätzen aufweist.

10. Verfahren nach Anspruch 8, wobei der Schritt zum Entfernen des übrigen unteren Abschnitts nach dem Schleifen die Schritte zum Abdecken eines Umfangsabschnitts der verbundenen unteren und oberen Substratabschnitte derart, dass ein Teil des unteren Abschnitts des unteren Substratabschnitts frei liegt, das Entfernen des Teils des unteren Abschnitts durch Nassätzen und das Abschneiden des Umfangsabschnitts der verbundenen unteren und oberen Substratabschnitte aufweist.

11. Verfahren nach Anspruch 9, wobei beim Nassätzen der gesamten unteren Fläche KOH verwendet wird.

12. Verfahren nach Anspruch 10, wobei beim Nassätzen des Abschnitts der unteren Fläche KOH verwendet wird.

13. Verfahren nach einem der Ansprüche 1 bis 12, wobei im Schritt zum Ausbilden der Bauelementschichten ein Halbleiterfertigungsprozess verwendet wird.

14. Verfahren nach Anspruch 13, wobei eine Entwurfsregel von 0,13 bis 0,03 $\mu$m auf den Halbleiterfertigungsprozess angewendet wird.

15. Verfahren nach einem der Ansprüche 1 bis 12, wobei der Schritt zum Ausbilden der Bauelementschichten die Schritte zum gleichzeitigen Ausbilden von TFT-Arrays und Treiberschaltungen auf der Einkristallschicht (100a), das Ausbilden von Farbfiltern (115, 116, 117) auf den TFT-Arrays und Treiberschaltungen, das Ausbilden von Pixelelektroden (118), die mit den TFTs verbunden sind, auf den Farbfiltern (115, 116, 117), das Ausbilden strukturierter Abstandselemente auf den Farbfiltern und das Ausbildet einer oder mehrerer Ausrichtungsschichten (120) auf den Pixelelektroden (118) und den Farbfiltern (115, 116, 117) aufweist.

16. Verfahren nach einem der Ansprüche 1 bis 12, wobei der Schritt zum Ausbilden der Bauelementschichten die Schritte zum gleichzeitigen Ausbilden von TFT-Arrays und Treiberschaltungen auf der Einkristallschicht (100a), das Ausbilden von Pixelelektroden (118), die mit den TFTs verbunden sind, auf den TFT-Arrays und den Treiberschaltungen, das Ausbilden von Farbfiltern (115, 116, 117) auf den Pixelelektroden, das Ausbilden strukturierter Abstandselemente auf den Farbfiltern (115, 116, 117) und das Ausbilden einer oder mehrerer Ausrichtungsschichten (120) auf den Pixelelektroden (118) und den Farbfiltern (115, 116, 117) aufweist.

17. Verfahren nach Anspruch 15, wobei nach dem Schritt zum Ausbilden der Farbfilter (115, 116, 117) ferner der Schritt zum Ausbilden einer organischen transparenten Schicht zum Ausgleichen des Dickenunterschieds über alle Farbfilter (115, 116, 117) vorgesehen ist.

18. Verfahren nach Anspruch 15, wobei nach dem Schritt zum gleichzeitigen Ausbilden der TFT-Arrays und der Treiberschaltungen auf der Einkristallschicht ferner der Schritt zum Aufbringen schwarzer Matrizen (Black Matrices) (114) auf den TFT-Bauelementen vorgesehen ist.

19. Verfahren nach Anspruch 15, wobei im Schritt zum Ausbilden der Bauelementschichten ein Halbleiterfertigungsprozess verwendet wird.

20. Verfahren nach einem der Ansprüche 1 bis 12, wobei der Schritt zum Herstellen des transparenten oberen Substratabschnitts (600) die Schritte zum Ausbilden von Elektroden auf einer Oberfläche eines flexiblen transparenten Substrats, das Ausbilden einer oder mehrerer Ausrichtungsschichten auf den Elektroden, und das Verbinden eines oberen Trägersubstrats mit der anderen Oberfläche des flexiblen transparenten Substrats durch eine Klebstoffschicht aufweist, und wobei der Schritt zum Flexibelmachen der miteinander verbundenen unteren und oberen Substratabschnitte den Schritt zum Entfernen des oberen Trägersubstrats aufweist.

21. Verfahren nach Anspruch 15, wobei der Schritt zum Herstellen des transparenten oberen Substratabschnitts (600) die Schritte zum Ausbilden von Elektroden auf einer Oberfläche eines flexiblen transparenten Substrats, das Ausbilden einer oder mehrerer Ausrichtungsschichten auf den Elektroden, und das Verbinden eines oberen Trägersubstrats mit der anderen Oberfläche des flexiblen transparenten Substrats durch eine Klebstoffschicht aufweist, und wobei der Schritt zum Flexibelmachen der miteinander verbundenen unteren und oberen Substratabschnitte den Schritt zum Entfernen des oberen Trägersubstrats aufweist.

22. Verfahren nach Anspruch 21, wobei der Schritt zum Entfernen des oberen Trägersubstrats (203) den Schritt zum Entfernen des oberen Trägersubstrats durch UV-Strahlung aufweist.

23. Verfahren nach einem der Ansprüche 1 bis 12, wobei der Schritt zum Herstellen des transparenten oberen Substratabschnitts (600) die Schritte zum Ausbilden von Elektroden auf einer Oberfläche eines flexiblen transparenten Substrats, das Verbinden eines oberen Trägersubstrats mit der anderen Oberfläche des flexiblen transparenten Substrats durch eine Klebstoffschicht und das Ausbilden einer oder mehrerer Ausrichtungsschichten auf den Elektroden aufweist, und wobei der Schritt zum Flexibelmachen der miteinander verbundenen unteren und oberen Substratabschnitte den Schritt zum Entfernen des oberen Trägersubstrats aufweist.

24. Verfahren nach Anspruch 21, wobei der Schritt zum Flexibelmachen der miteinander verbundenen unteren und oberen Substratabschnitte den Schritt zum Entfernen des gesamten unteren Abschnitts des unteren Substratabschnitts durch Nassätzen aufweist.

25. Verfahren nach Anspruch 21, wobei der Schritt zum Flexibelmachen der miteinander verbundenen unteren und oberen Substratabschnitte die Schritte zum Abdecken eines Umfangsabschnitts der verbundenen unteren und oberen Substratabschnitte derart, dass ein Teil des unteren Abschnitts des unteren Substratabschnitts frei liegt, das Entfernen des Teils des unteren Abschnitts durch Nassätzen und das Abschneiden des Umfangsabschnitts der verbundenen unteren und oberen Substratabschnitts aufweist.

26. Verfahren nach Anspruch 19, wobei der Schritt zum Herstellen des transparenten oberen Substratabschnitts die Schritte zum Ausbilden von Elektroden auf einer Oberfläche eines flexiblen transparenten Substrats, das Ausbilden einer oder mehrerer Ausrichtungsschichten auf den Elektroden, und das Verbinden eines oberen Trägersubstrats mit der anderen Oberfläche des flexiblen transparenten Substrats durch eine Klebstoffschicht aufweist, und wobei der Schritt zum Flexibelmachen der miteinander verbundenen unteren und oberen Substratabschnitte die Schritte zum Entfernen des gesamten unteren Abschnitts durch Nassätzen mit KOH und das Entfernen des oberen Trägersubstrats durch UV-Strahlung aufweist.

## Revendications

1. Procédé de fabrication d'un dispositif électro-optique flexible, comprenant les étapes consistant à :

   fabriquer une partie d'un substrat inférieur (100) dans lequel une couche monocristalline (100a) est formée sur la surface supérieure de ladite partie du substrat inférieur (100) ;
   former des couches de dispositif dans lequel des dispositifs électroniques sont formés sur la couche monocristalline (100a) ;
   fabriquer une partie d'un substrat supérieur (600) transparente avec un substrat de support supérieur (203) lié à celle-ci ;
   lier ladite partie du substrat inférieur (100) et ladite partie du substrat supérieur (600) ;
   injecter un matériau électro-optique entre ladite partie de substrat inférieure (100) et ladite partie du substrat supérieur (600) ;
   et rendre flexibles lesdites parties des substrats inférieur et supérieur liées;
   dans lequel ladite partie du substrat supérieur (600) est flexible, et l'étape consistant à rendre flexibles lesdites parties des substrats inférieur et supérieur liées comprend l'étape consistant à maintenir les parties des substrats inférieur et supérieur liées par un gabarit de gravure (300) et enlever une partie inférieure (100c) de ladite partie du substrat inférieur (100) ;
   enlever ledit substrat de support supérieur (203).

2. Procédé selon la revendication 1, dans lequel ladite couche monocristalline (100a) sur ladite partie du substrat inférieur (100) comprend une couche monocristalline de nano silicium sur isolant au moyen d'un procédé de fabrication de silicium sur isolant.

3. Procédé selon la revendication 1, dans lequel l'étape consistant à rendre flexibles lesdites parties des substrats inférieur et supérieur liées comprend l'étape consistant à enlever la totalité de la partie inférieure (100c) de ladite partie du substrat inférieur (100) par gravure humide de celle-ci.

4. Procédé selon la revendication 1, dans lequel l'étape consistant à rendre flexibles lesdites parties des substrats inférieur et supérieur liées comprend les étapes consistant à couvrir une partie périphérique desdites parties des substrats inférieur et supérieur liées pour exposer une partie de la partie inférieure (100c) de ladite partie du substrat inférieur (100), enlever la partie de la partie inférieure (100c) par gravure humide de celle-ci, et couper la partie périphérique desdites parties des substrats inférieur et supérieur liées.

5. Procédé selon la revendication 3, dans lequel KOH est utilisé dans la gravure humide de la totalité de la surface inférieure.

6. Procédé selon la revendication 4, dans lequel KOH est utilisé dans la gravure humide de la partie de la surface inférieure.

7. Procédé selon la revendication 1, dans lequel ladite partie du substrat supérieur (600) transparente comprend un substrat de support supérieur (203) ; et dans lequel l'étape consistant à rendre flexibles lesdites parties des substrats inférieur et supérieur liées comprend les étapes consistant à meuler la partie inférieure (100c) de ladite partie du substrat inférieur (100) à une épaisseur prédéterminée, enlever le substrat de support supérieur (203), et enlever la partie inférieure restante après meulage.

8. Procédé selon la revendication 1, dans lequel ladite partie du substrat supérieur (600) transparente comprend un substrat de support supérieur ; et dans lequel l'étape consistant à rendre flexibles lesdites parties des substrats inférieur et supérieur liées comprend les étapes consistant à meuler la partie inférieure de ladite partie du substrat inférieur à une épaisseur prédéterminée, enlever la partie inférieure restante après meulage, et enlever le substrat de support supérieur.

9. Procédé selon la revendication 8, dans lequel l'étape consistant à enlever la partie inférieure restante après meulage comprend l'étape consistant à enlever la totalité de la partie inférieure de ladite partie du substrat inférieur par gravure humide de celle-ci.

10. Procédé selon la revendication 8, dans lequel l'étape consistant à enlever la partie inférieure restante après meulage comprend les étapes consistant à couvrir une partie périphérique desdites parties des substrats inférieur et supérieur liées pour exposer une partie de la partie inférieure de ladite partie du substrat inférieur, enlever la partie de la partie inférieure par gravure humide de celle-ci, et couper la partie périphérique desdites parties des substrats inférieur et supérieur liées.

11. Procédé selon la revendication 9, dans lequel KOH est utilisé dans la gravure humide de la totalité de la surface inférieure.

12. Procédé selon la revendication 10, dans lequel KOH est utilisé dans la gravure humide de la partie de la surface inférieure.

13. Procédé selon l'une quelconque des revendications 1 à 12, dans lequel l'étape de formation des couches de dispositif emploie un procédé de fabrication de semi-conducteur.

14. Procédé selon la revendication 13, dans lequel une règle de tracé de 0,13 à 0,03 $\mu$m est appliquée sur le procédé de fabrication de semi-conducteur.

15. Procédé selon l'une quelconque des revendications 1 à 12, dans lequel l'étape de formation des couches de dispositif comprend les étapes consistant à former des réseaux de transistors à couches minces et des circuits d'attaque sur ladite couche monocristalline (100a) en même temps, former des filtres de couleur (115, 116 , 117) sur lesdits réseaux de transistors à couches minces et circuits d'attaque, former des électrodes de pixel (118) qui sont reliées aux transistors à couches minces sur lesdits filtres de couleur (115, 116, 117), former des éléments d'espacement à motifs sur lesdits filtres de couleur, et former un ou plusieurs films d'alignement (120) sur lesdites électrodes de pixel (118) et lesdits filtres de couleur (115, 116, 117).

**16.** Procédé selon l'une quelconque des revendications 1 à 12, dans lequel l'étape de formation des couches de dispositif comprend les étapes consistant à former des réseaux de transistors à couches minces et des circuits d'attaque sur ladite couche monocristalline (100a) en même temps, former des électrodes de pixel (118) qui sont reliées aux transistors à couches minces sur lesdits réseaux de transistors à couches minces et circuits d'attaque, former des filtres de couleur (115, 116, 117) sur lesdites électrodes de pixel (118), former des éléments d'espacement à motifs sur lesdits filtres de couleur (115, 116, 117), et former un ou plusieurs films d'alignement (120) sur lesdites électrodes de pixel (118) et lesdits filtres de couleur (115, 116, 117).

**17.** Procédé selon la revendication 15, après l'étape de formation desdits filtres de couleur (115, 116, 117), comprenant en outre l'étape consistant à former une couche transparente organique pour compenser la différence d'épaisseur à travers les filtres de couleurs (115, 116, 117).

**18.** Procédé selon la revendication 15, après l'étape de formation de réseaux de transistors à couches minces et de circuits d'attaque sur ladite couche monocristalline en même temps, comprenant en outre l'étape consistant à des matrices noires (114) au-dessus des dispositifs de transistors à couches minces.

**19.** Procédé selon la revendication 15, dans lequel l'étape de formation des couches de dispositif emploie un procédé de fabrication de semi-conducteur.

**20.** Procédé selon l'une quelconque des revendications 1 à 12, dans lequel l'étape de fabrication de la partie du substrat supérieur (600) transparente comprend les étapes consistant à former des électrodes sur une surface d'un substrat transparent flexible, former une ou plusieurs couches d'alignement sur lesdites électrodes, et lier un substrat de support supérieur sur l'autre surface du substrat transparent flexible avec un film adhésif; et l'étape consistant à rendre flexibles lesdites parties des substrats inférieur et supérieur liées comprend l'étape consistant à enlever ledit substrat de support supérieur.

**21.** Procédé selon la revendication 15, dans lequel l'étape de fabrication de la partie du substrat supérieur (600) transparente comprend les étapes consistant à former des électrodes sur une surface d'un substrat transparent flexible, former une ou plusieurs films d'alignement sur lesdites électrodes, et lier un substrat de support supérieur sur l'autre surface du substrat transparent flexible avec un film adhésif ; et l'étape consistant à rendre flexibles lesdites parties des substrats inférieur et supérieur liées comprend l'étape consistant à enlever ledit substrat de support supérieur.

**22.** Procédé selon la revendication 21, dans lequel l'étape consistant à enlever ledit substrat de support supérieur (203) comprend l'étape consistant à enlever celui-ci avec des UV.

**23.** Procédé selon l'une quelconque des revendications 1 à 12, dans lequel l'étape de fabrication de la partie du substrat supérieur (600) transparente comprend les étapes consistant à former des électrodes sur une surface d'un substrat transparent flexible, lier un substrat de support supérieure sur l'autre surface du substrat transparent flexible avec un film adhésif, et former un ou plusieurs films d'alignement sur lesdites électrodes ; et l'étape consistant à rendre flexibles lesdites parties des substrats inférieur et supérieur liées comprend l'étape consistant à enlever ledit substrat de support supérieure.

**24.** Procédé selon la revendication 21, dans lequel l'étape consistant à rendre flexibles lesdites parties des substrats inférieur et supérieur liées comprend l'étape consistant à enlever la totalité de la partie inférieure de ladite partie du substrat inférieur par gravure humide de celle-ci.

**25.** Procédé selon la revendication 21, dans lequel l'étape consistant à rendre flexibles lesdites parties des substrats inférieur et supérieur liées comprend les étapes consistant à couvrir une partie périphérique desdites parties de substrat inférieur et supérieur liées pour exposer une partie de la partie inférieure de ladite partie du substrat inférieur, enlever la partie de la partie inférieure par gravure humide de celle-ci, et couper la partie périphérique desdites parties des substrats inférieur et supérieur liées.

**26.** Procédé selon la revendication 19, dans lequel l'étape de fabrication de la partie du substrat supérieur transparente comprend les étapes consistant à former des électrodes sur une surface d'un substrat transparent flexible, former une ou plusieurs films d'alignement sur lesdites électrodes, et lier un substrat de support supérieur sur l'autre surface du substrat transparent flexible avec un film adhésif; et l'étape consistant à rendre flexibles lesdites parties des substrats inférieur et supérieur liées comprend les étapes consistant à enlever la totalité de la partie inférieure par gravure humide de celle-ci avec du KOH et enlever ledit substrat de support supérieur avec des UV.

[Fig. 1]

( a )

data driver circuit region

gate driver circuit region

pixel array region

( b )

801

802

804

800

803

[Fig. 2]

(a)

100a                                100b

}100

100c

(b)

101                  100b

NMOS       PMOS         NMOS     Storage Cap.

driver circuit device region          pixel array region     100c

}100

[Fig. 3]

(a)

101   102                    100b

NMOS      PMOS      NMOS      Storage Cap.                    } 100

driver circuit device region      100c        pixel array region

B or P Ion

(b)

102
103                    104

NMOS      PMOS      NMOS      Storage Cap.                    } 100

driver circuit device region              pixel array region

(c)

105        105        105        105-1
                                   102
                                   103

NMOS      PMOS      NMOS      Storage Cap.                    } 100

driver circuit device region              pixel array region

N - ( P ) Ion

(d)

105        105        105  106  105-1
                                   102
                                   103

NMOS      PMOS      NMOS      Storage Cap.                    } 100

driver circuit device region              pixel array region

[Fig. 4]

(a)

106    107  105    102
                    103

NMOS      PMOS      NMOS    Storage Cap.

driver circuit device region        pixel array region

100

(b)

108   108    108   108    108   108   108  105  108   102
                              106                     103

NMOS      PMOS      NMOS    Storage Cap.

driver circuit device region        pixel array region

100

[Fig. 5]

N + ( P ) Ion

↓ ↓ ↓ ↓ ↓ ↓ ↓ ↓ ↓ ↓ ↓ ↓ ↓ ↓

(a)

106   108   104  105    102
        109                103

NMOS      PMOS      NMOS    Storage Cap.

driver circuit device region        pixel array region

100

P + ( B ) Ion

↓ ↓ ↓ ↓ ↓ ↓ ↓ ↓ ↓ ↓ ↓ ↓ ↓ ↓

(b)

110    106   108 109 104  105    102
                                  103

NMOS      PMOS      NMOS    Storage Cap.

driver circuit device region        pixel array region

100

[Fig. 6]

(a)

110  106        106 109  111 105  102
                                    103

NMOS      PMOS        NMOS      Storage Cap.
100

driver circuit device region        pixel array region

(b)

110 106  22   109  106  112  111 105  102
                                       103

NMOS      PMOS        NMOS      Storage Cap.
100

driver circuit device region        pixel array region

[Fig. 7]

(a)

110  106     109  106  112  113
                       111   105  102
                                  103

NMOS      PMOS        NMOS      Storage Cap.
100

driver circuit device region        pixel array region

(b)

114   112   113
110  106      106 )109 111 ) 105  102
                                   103

NMOS      PMOS        NMOS      Storage Cap.
100

driver circuit device region        pixel array region

[Fig. 8]

(a)

106 110  115  114 112  111 105  102  103  106 109  100

driver circuit device region    pixel (Red)

(b)

106 110  115  116  114 112  111 105  102  103  106 109  100

driver circuit device region    pixel (Red)    pixel (Green)

(c)

106 110  115  116  117 114 112  111 105  102  103  100

driver circuit device region    pixel (Red)    pixel (Green)    pixel (Blue)

[Fig. 9]

(a)

115  110  114  23 112 111 102 113 105 103 118

NMOS  PMOS  NMOS  Storage Cap.  100

driver circuit device region  109 106  pixel array region

(b)

119  114 112 113 105 103

115  120  111 102 118

NMOS  PMOS  NMOS  Storage Cap.  100

driver circuit device region  110 109 106  pixel array region

[Fig. 10]

(a)  200
201

(b)  203
202
200
201

(c)  203
202
200
201
204

[Fig. 11]

119    205

203
202
200
201
204

206   115   120   114  112
118
113
111
105
102
103

100

NMOS        PMOS        NMOS      Storage Cap.

driver circuit device region  110  109 _106   pixel array region

[Fig. 12]

(a)

301
100c
100b

300

203

(b)

100b

203

[Fig. 13]

(a)

301

300

100c

100b

203

(b)

300

100c

100b

203

(c)

100b

203

[Fig. 14]

[Fig. 15]

[Fig. 16]

[Fig. 17]

[Fig. 18]

[Fig. 19]

(a)

400 ⎫
200 ⎬ 600
201 ⎭

205

500

403

100b

(b)

400 ⎫
200 ⎬ 600
201 ⎭

205

500
100b
401

403

[Fig. 20]

119                    205

203
202
200
201
204

206    115    120    114    112    118
113
111
105
102
103

100

100c

NMOS    PMOS         NMOS    Storage Cap.

driver circuit device region    110  109  106    pixel array region

[Fig. 21]

(a)

301

100c
100b

300

(b)

100b

203

[Fig. 22]

[Fig. 23]

(a)

driver circuit device region    pixel array region

(b)

driver circuit device region    pixel array region

(c)

driver circuit device region    pixel array region

(d)

driver circuit device region    pixel array region

(e)

driver circuit device region    pixel array region

(f)

driver circuit device region    pixel array region

[Fig. 24]

**EP 1 751 789 B1**

REFERENCES CITED IN THE DESCRIPTION

**Patent documents cited in the description**

- WO 2004042780 A
- US 10391297 B